# EUROPÄISCHE PATENTSCHRIFT

(11) **EP 1 683 405 B1**
(45) Veröffentlichungstag und Bekanntmachung des Hinweises auf die Patenterteilung: **29.08.2007**
(21) Anmeldenummer: 04797538.8
(22) Anmeldetag: 03.11.2004
(51) Int. Cl.: H05K 13/04

(54) **CHIPENTFERNER**
CHIP REMOVER
EXTRACTEUR DE PUCE

(30) Priorität: 10.11.2003 CH 193203
(43) Veröffentlichungstag der Anmeldung: 26.07.2006
(73) Patentinhaber: Tresky, Miroslav, 8803 Rüschlikon (CH)
(72) Erfinder: Tresky, Miroslav, 8803 Rüschlikon (CH)
(74) Vertreter: Spicak-Malcova, Hana
(86) Internationale Anmeldenummer: PCT/EP2004/012397
(87) Internationale Veröffentlichungsnummer: WO 2005/046300

(56) Entgegenhaltungen:
- WO-A-92/07455
- US-A- 4 366 925

## Beschreibung

Die Erfindung betrifft einen Chipentferner gemäss dem Oberbegriff des Anspruches 1, ein Verfahren zum Betrieb des Chipentferners, sowie eine Verwendung des Chipentferners.

Ein Chipentferner dieser Art ist beispielsweise in der WO 92/07455 (Fig. 4) offenbart. Bei diesem Chipentferner werden wahlweise verschiedene, je nach Grösse und Form des zu entfernenden Chips auswechselbare Werkzeuge in Form von Meisseln in eine mit einem Schlagkolben versehene Einrichtung manuell eingesetzt, durch welche die zur Trennung des Chips vom Chip-Träger notwendige Scherkraft erzeugt wird. Diese Einrichtung ist in einer schwenkbar an einem vertikalverstellbaren Rahmen angeordneten Halterung angeordnet und dabei relativ zum auf einer Arbeitsfläche (einem XY-Positionierungstisch) positionierten Chip-Träger bzw. Chip verstellbar. Der Chipentferner ist ferner mit einer unteren Wärmequelle für den Chip-Träger sowie mit einer oberen Wärmequelle für den Chip versehen. Bei diesem Chipentferner ist es von Nachteil, dass die Winkeleinstellung des Werkzeuges bzw. der ganzen Einrichtung zum Erzeugen der Scherkraft zu der Arbeitsfläche bei unterschiedlich grossen Chips unterschiedlich ist, so dass auch die zum Abtrennen des Chips vom Träger notwendige Scherkraftkomponente jeweils ändert. Je grösser der Chip, desto grösser der Winkel, d.h. desto kleiner die Scherkraftkomponente und desto grösser die Gefahr, dass der Träger durch das Werkzeug beschädigt wird. Weiter besteht die Gefahr, dass die obere Wärmequelle, bei der es sich in der Regel um eine Heissgasdüse handelt, nicht nur den zu entfernenden Chip sondern auch benachbarte Bauteile des Chip-Trägers erwärmt und beschädigt.

Der vorliegenden Erfindung liegt die Aufgabe zugrunde, einen Chipentferner der eingangs genannten Art zu schaffen, der die Erzeugung einer optimalen Scherkraft für jede Chipgrösse ermöglicht und bei dem die Gefahr, dass von der oberen Wärmequelle nicht nur der zu entfernenden Chip sondern auch benachbarte Bauteile des Chip-Trägers erwärmt und dabei beschädigt werden, weitgehend eliminiert wird. Weiter soll ein optimales Verfahren zum Betrieb des Chipentferners vorgeschlagen werden, das dem Anwendungsbereich und beispielsweise dem Material des Chip-Trägers Rechnung trägt.

Diese Aufgabe wird erfindungsgemäss durch einen Chipentferner mit den Merkmalen des Anspruches 1 sowie durch ein Verfahren nach Anspruch 15 gelöst.

Weitere bevorzugte Ausgestaltungen des erfindungsgemässen Chipentferners bilden den Gegenstand der abhängigen Ansprüche.

Der erfindungsgemässe Chipentferner gewährleistet für jede Chipgrösse eine optimale Erzeugung der Scherkraft sowie eine gezielte Erwärmung des zu entfernenden Chips. Zudem ist das Umstellen auf verschiedene Chipgrössen beim erfindungsgemässen Chipentferner wesentlich erleichtert. Somit sind auch Bedingungen zum Automatisieren möglichst vieler Operationen geschaffen. In einer besonders bevorzugten Weise kann die Erwärmung der Chipoberfläche und/oder die Grösse der Scherkraft mit entsprechenden Sensoren ermittelt und eingestellt werden. Ebenfalls besonders vorteilhaft ist die Möglichkeit, die Scherkraft statisch und/oder dynamisch zu erzeugen. Dies ermöglicht auch eine dem jeweiligen Anwendungsbereich und beispielsweise dem Material des Chip-Trägers gerechte Arbeitsweise, bei der entweder nach einer anfänglichen Erwärmung des Chips auf eine vorgegebene Temperatur eine zur Trennung des Chips vom Träger notwendige statische Kraft und/oder Schlagkraft erzeugt wird, oder beim Einstellen und Ausüben einer vorgegebenen statischen Kraft die Temperatur des Chips auf einen zur Trennung des Chips vom Träger notwendigen Wert erhöht wird. Dadurch, dass in einer bevorzugten Weise die Scherkraft nicht nur dynamisch, durch eine Schlagkraft, oder in Kombination der Schlagkraft mit der statischen Einwirkung erzeugt werden kann, sondern auch nur rein statische Scherkrafteinstellung möglich ist, kann der Chipentferner in einer besonders vorteilhaften Weise auch als ein sogenannter Schertester eingesetzt werden, indem die Chips einer vorgegebenen Scherkraft ausgesetzt und dabei die Verbindung des Chips mit dem Chipträger auf ihre Tauglichkeit geprüft werden kann. Bis jetzt sind solche Schertester nur als eigenständige, vom eigentlichen Chipentferner getrennte Einheiten bekannt.

Die Erfindung wird im folgenden anhand der Zeichnung näher erläutert.

Es zeigen:
- Fig. 1: schematisch ein erstes Ausführungsbeispiel eines erfindungsgemässen Chipentferners in Frontansicht;
- Fig. 2: einen Teil des Chipentferners nach Fig. 1 im vergrösserten Massstab;
- Fig. 3: ein zweites Ausführungsbeispiel eines erfindungsgemässen Chipentferners in Frontansicht;
- Fig. 4: ein drittes Ausführungsbeispiel eines erfindungsgemässen Chipentferners in Frontansicht, mit einem Revolverkopf für auswechselbare Heizelemente;
- Fig. 5: ein erstes Ausführungsbeispiel eines Heizelementes für den Chipentferner nach Fig. 4 im Längsschnitt;
- Fig. 6: ein zweites Ausführungsbeispiel eines Heizelementes für den Chipentferner nach Fig. 4 im Längsschnitt;
- Fig. 7: ein drittes Ausführungsbeispiel eines Heizelementes, geeignet für Chipentferner nach Fig. 1, 2 oder 4 im Längsschnitt;
- Fig. 8: eine vierte Variante eines Heizelementes im Längsschnitt;
- Fig. 9: das Heizelement nach Fig. 8 in Draufsicht; und
- Fig. 10: eine vierte Variante eines Heizelementes im Längsschnitt.

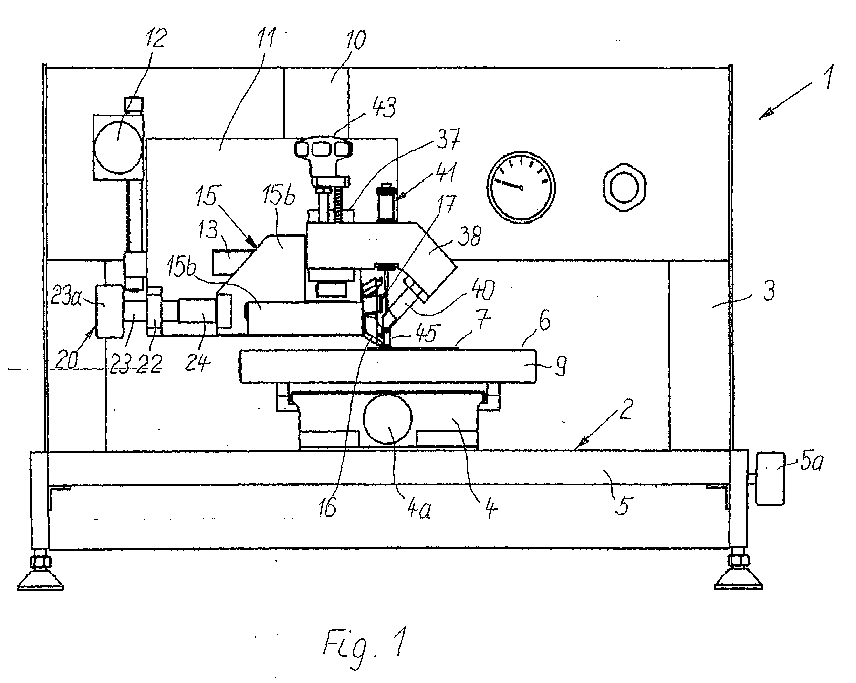

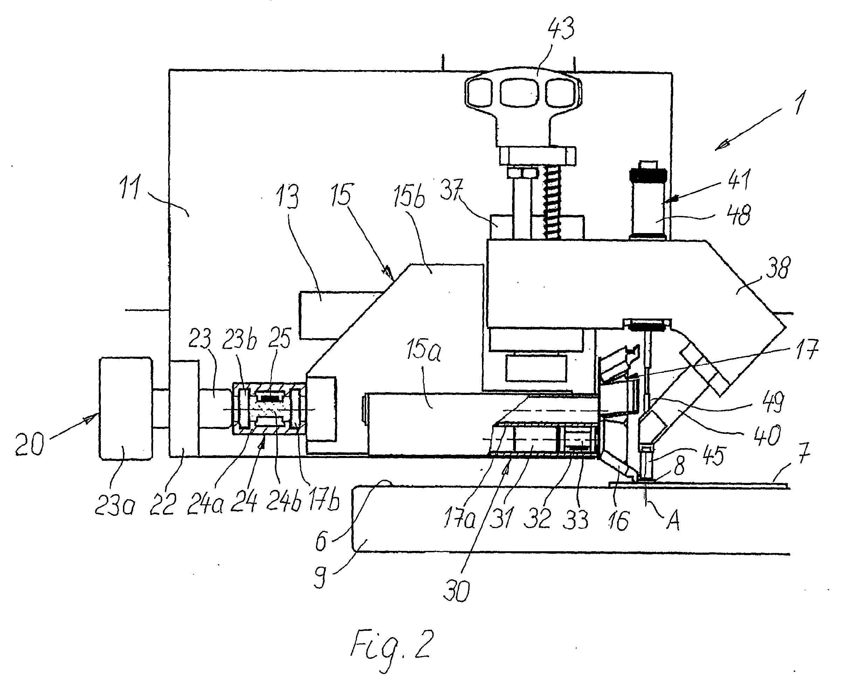

Gemäss Fig. 1 weist ein Chipentferner 1 einen an sich bekannten XY-Positionierungstisch 2 sowie einen Rahmen 3 auf. Der Positionierungstisch 2 umfasst XY-Führungen 4, 5 mit entsprechenden Betätigungsgriffen 4a, 5a sowie eine obere Arbeitsfläche 6, auf welcher ein Chip-Träger 7 mit dem zu entfernenden, aus Fig. 2 ersichtlichen Chip 8 positioniert ist. Der Chip 8 ist auf dem Chip-Träger 7 geklebt, und zwar in der Regel mittels eines Epoxydklebers, dessen Festigkeit mit ansteigender Temperatur sinkt. Die Chipentfernung erfolgt daher unter Erwärmung sowohl des Chip-Trägers 7 als auch des Chips 8. Unterhalb der Arbeitsfläche 6 ist eine untere Wärmequelle 9, eine Heizplatte, angeordnet, die zum Erwärmen des Chip-Trägers 7 vorgesehen ist.

Am Rahmen 3 ist eine Vertikalführung 10 angebracht, die zum Verstellen einer Platte 11 vorgesehen ist. Die Vertikalverstellung wird mittels eines Antriebs 12 bewerkstelligt. An der Platte 1 1 ist eine Horizontalführung 13 für eine Einrichtung 15 angeordnet, die dazu bestimmt ist, auf ein Werkzeug 16 eine Scherkraft auszuüben, um die Trennung des Chips 8 vom Chip-Träger 7 zu bewirken. Gemäss Fig. 1 und 2 sind mehrere Werkzeuge 16 in einem um eine gegebenenfalls horizontale Achse drehverstellbaren Werkzeugkopf 17 angeordnet, die je nach Form und Grösse des zu entfernenden Chips durch Drehverstellen des Werkzeugkopfes 17 wahlweise in Wirkverbindung mit der Einrichtung 15 zur Erzeugung von Scherkraft gebracht werden können. Dabei sind die Werkzeuge 16 tangential am im wesentlichen kegelförmigen Werkzeugkopf 17 angeordnet, derart, dass das zum Einsatz vorgesehene Werkzeug 16 in eine auf die Arbeitsfläche 6 schräg nach unten gerichtete Stellung gebracht werden kann. Eine den Werkzeugkopf 17 tragende Welle 17a (vgl. Fig. 2), die möglichst tief oberhalb der Arbeitsfläche 6 angeordnet ist, ist teilweise in einem Gehäuseteil 1 5a der Vorrichtung 15 untergebracht, der mit einem auf der Horizontalführung 13 geführten Block 15b fest verbunden ist.

Die Einrichtung 15 zur Erzeugung von Scherkraft umfasst einen mit der Welle 17a zusammenwirkenden, ersten Teil 20 zur Erzeugung einer statischen Scherkraft, der eine mit einem an der Platte 11 angebrachten Gewindeteil 22 zusammenwirkende, horizontal gerichtete Schraube 23 mit einem Stellkopf 23a aufweist. Die Schraube 23 dient einerseits als ein Verstellelement zur horizontalen Verstellung der Einrichtung 15 auf der Horizontalführung 13 und anderseits als ein auf die Welle 17a axial einwirkendes Kraftelement. Die Schraube 23 ist mit der Welle 17a über einen Kupplungsteil 24 wirkverbunden. In eine hülsenförmige Fassung 24a des Kupplungsteils 24 ist gemäss Fig. 2 einerseits ein tellerförmiges Ende 23b der drehbeweglichen Schraube 23 und anderseits eine auf der Welle 17a (die nur bei Auswahl des Werkzeuges 16 drehverstellbar, ansonsten jedoch drehfest ist) angeordnete Scheibe 17b eingebaut. Zwischen dem Schraubenende 23b und der Scheibe 17b ist ein axial gerichteter Zapfen 24b angeordnet, der mit einem Kraftsensor 25 zur Messung der statischen Kraft ausgestattet ist.

Die Einrichtung 15 ist ferner mit einem zweiten, aus Fig. 2 ersichtlichen Teil 30 zur Erzeugung einer Schlagkraft versehen. Dieser Teil 30 ist unterhalb der Welle 17a im Gehäuseteil 15a der Vorrichtung 15 untergebracht und weist einen horizontalbeweglichen Schlagkolben 31 auf, der über einen mit einem Schlagkraftsensor 32 ausgestatteten, axialbeweglichen Zapfen 33 mit dem Werkzeugkopf 17 bzw. dem zum Einsatz vorgesehenen Werkzeug 16 zusammenwirken kann. Die Betätigung des Schlagkolbens 31 kann in einer z.B. aus der WO 92/07455 bekannten Weise pneumatisch, vakuum-pneumatisch oder elektromagnetisch erfolgen, wobei einzelne Schläge oder wiederholte Schläge mit einer Frequenzeinstellung durchgeführt werden können.

Die beiden Teile 20, 30 der Einrichtung 15 zur Erzeugung von Scherkraft können einzeln oder in Kombination eingesetzt werden, wobei die erzeugten statischen oder dynamischen Kräfte horizontal gerichtet sind und dadurch eine optimale Scherkrafterzeugung gewährleistet ist.

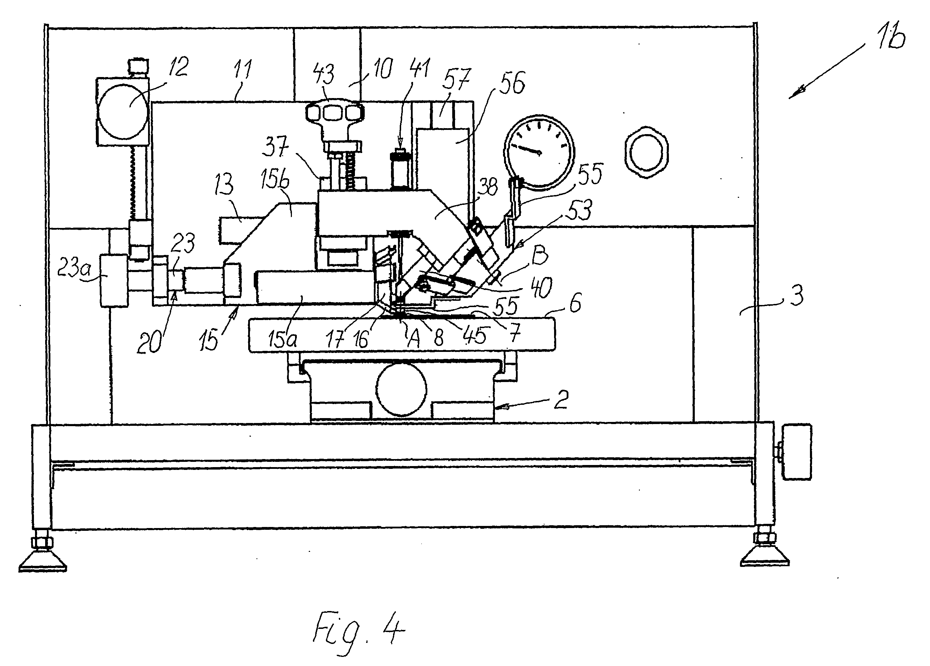

An der höhenverstellbaren Platte 11 ist eine weitere vertikale Führung 37 für einen Halter 38 angebracht, in welchem einerseits eine obere Wärmequelle 40 und anderseits eine Temperatursensor-Einheit 41 eingebaut sind. Es ist ferner ein der Chipgrösse entsprechendes, auswechselbares Heizelement 45 für ein gezieltes Erwärmen des Chips 8 vorgesehen, welches auf die Chipoberfläche in einer bezüglich des Chips 8 zentralen Heizachse A (Fig. 2) aufgesetzt oder in unmittelbare Nähe dieser Chipoberfläche gebracht werden kann. Verschiedene Ausführungsformen der Heizelemente 45 und der Wärmequelle 40 werden weiter unten ausführlich beschrieben. Bei dem in Fig. 1 und 2 dargestellten Ausführungsbeispiel wird das Heizelement 45 zusammen mit der Wärmequelle 40 durch die Vertikalverstellung des Halters 38 auf die Chipoberfläche aufgesetzt (die Wärmequelle 40 ist zwar im Halter 38 schräg zur Heizachse A eingebaut, weist jedoch einen unteren, mit dem Heizelement 45 verbundenen Teil auf, der in der Heizachse A liegt). Die Vertikalverstellung des Halters 38 mit der Wärmequelle 40 und der Temperatursensor-Einheit 41 erfolgt über ein Betätigungselement 43. Es besteht jedoch die Möglichkeit, das Aufsetzen des Heizelementes 45 von der Vertikalverstellung des Halters 38 bzw. der Wärmequelle 40 zu separieren, wie ebenfalls weiter unten anhand der Fig. 4 näher dargelegt wird.

Die Temperatursensor-Einheit 41 weist einen in der Heizachse A liegenden, in einer Führung 48 federnd vertikalgeführten Temperatursensor 49 auf, der entweder federnd auf die Chipoberfläche aufgesetzt oder in unmittelbare Nähe dieser Chipoberfläche gebracht werden kann.

Um einen bestimmten Chip 8 vom Chip-Träger 7 zu trennen, wird zuerst der auf der Arbeitsfläche 6 positionierte Chip 8 mittels des XY-Positionierungstisches 2 in eine bezüglich der vertikalen Heizachse A koaxiale bzw. zentrale Stellung gebracht. Es wird ein für diesen Chip 8 geeignetes Werkzeug 16 gewählt und durch das Drehverstellen des Werkzeugkopfes 17 in die auf die Arbeitsfläche 6 schräg nach unten gerichtete Stellung gebracht. Das Werkzeug 16 wird durch horizontales Verstellen der Einrichtung 15, mittels der Schraube 23, in einen der Chipgrösse entsprechenden Abstand von der Heizachse A eingestellt und durch die Vertikalverstellung der Platte 11 auf die Arbeitsfläche 6 neben dem Chip bzw. zu einer Chipkante hin aufgesetzt. Nun kann beispielsweise nach einer Erwärmung des Chips 8 durch die obere Wärmequelle 40 auf eine vorgegebene Temperatur z.B. von 150°C (neben der Erwärmung des Chip-Trägers 7 durch die Heizplatte 9) mittels der Schraube 23 eine bestimmte, statische Kraft bzw. Vorspannung erzeugt werden. Genügt diese nicht zum Abtrennen des Chips 8, so kann entweder die statische Kraft weiter erhöht werden, bis die Trennung des Chips 8 erfolgt, oder es kann über den Schlagkolben 31 eine dynamische Kraft auf den Chip 8 ausgeübt werden. Selbstverständlich kann auch der mit dem Schlagkolben 31 versehene Teil 30 direkt nach dem Einstellen des Werkzeuges 16 zu der Chipkante hin eingesetzt werden, ohne dass zuvor die statische Vorspannung erzeugt wird.

Eine weitere mögliche Vorgehensweise neben dem vorstehend beschriebenen Kraftmodus besteht in einem sogenannten Temperaturmodus, bei dem nach dem Einstellen des Werkzeuges 16 gegenüber der Heizachse A bzw. der Chipkante zuerst eine vorgegebene, statische Kraft eingestellt und anschliessend die Chip-Temperatur auf einen zur Trennung des Chips notwendigen Wert erhöht wird.

Welches von den beiden vorstehend erwähnten möglichen Verfahren gewählt wird, hängt nicht nur von der Chipgrösse ab, sondern vor allem vom Anwendungsbereich der zu reparierenden Schaltungen, und insbesondere vom Material des Chip-Trägers 7, bei dem es sich um einen keramischen Substrat, eine Leiterplatte etc. handeln kann, wobei zu überlegen ist, ob bei der Chipentfernung eher eine Gefahr einer mechanischen Beschädigung des Chip-Trägers (z.B. des keramischen Substrats) bei zu grossen Kräften oder die Gefahr einer thermischen Beschädigung (z.B. der Leiterplatte) bei zu hohen Temperaturen besteht.

Schliesslich bietet der erfindungsgemässe Chipentferner die Möglichkeit zur Durchführung von Schertests, die ohne Erwärmung oder bei einer Erwärmung auf eine Betriebstemperatur durchgeführt werden können, und bei denen die Chips 8 einer vorgegebenen Scherkraft ausgesetzt werden und dabei die Verbindung des Chips 8 mit dem Chip-Träger 7 auf ihre Tauglichkeit geprüft werden kann, und zwar können sowohl Klebeverbindungen als auch mit anderen Verbindungstechniken bewerkstelligte Verbindungen (z.B. eutektische Verbindungen) getestet werden. Bis anhin werden solche Schertests nur an separaten Schertestgeräten durchgeführt, bei denen eine Chiptrennung nur bei defekten Verbindungen erfolgt, mittels denen jedoch die zwar gut haftenden, jedoch beispielsweise falsch angebrachten (z.B. um 90° falsch ausgerichteten) Chips 8 garnicht entfernt werden können.

Ein wesentlicher Vorteil des erfindungsgemässen Chipentferners 1 besteht darin, dass die einmal durchgeführte Einstellung des Werkzeuges 16 gegenüber der Heizachse A bei einer Reparatur von mehreren, mit dem Chip 8 gleicher Grösse versehenen Chip-Trägern 7 nicht jedesmal wiederholt werden muss, sondern lediglich die Platte 11 mit den sämtlichen Bauteilen für den Wechsel der Chip-Träger angehoben und wieder nach unten verstellt zu werden braucht.

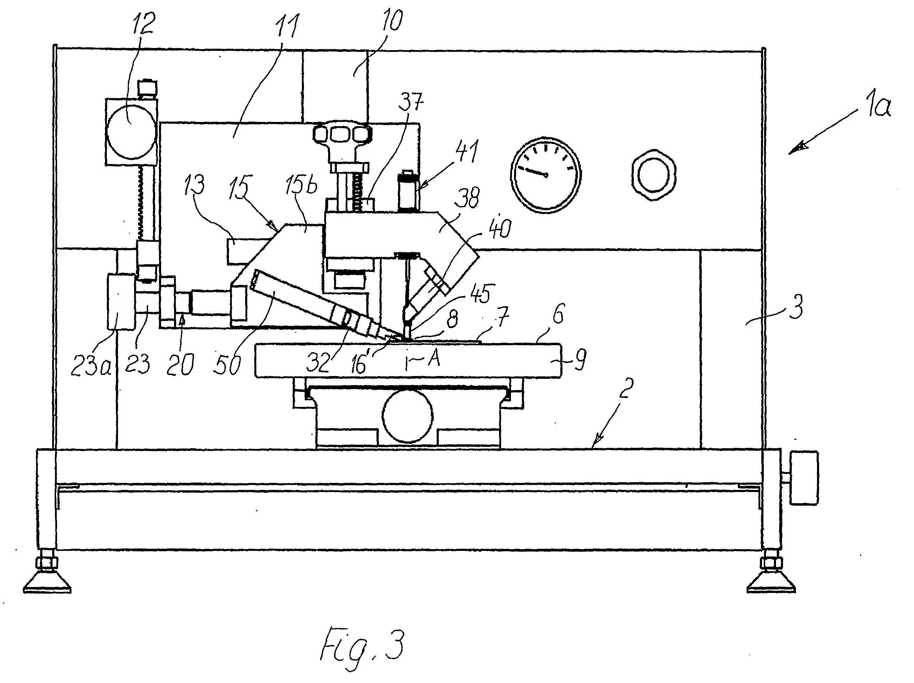

In Fig. 3 ist ein weiteres Ausführungsbeispiel eines Chipentferners 1 a dargestellt (die gleichbleibenden Teile sind mit den gleichen Bezugsziffern bezeichnet). Im Unterschied zum Chipentferner 1 nach Fig. 1 und 2 ist bei dieser Ausführungsform kein drehverstellbarer Werkzeugkopf vorgesehen, sondern am Block 1 5b der Einrichtung 15 zur Erzeugung der Scherkraft ist ein Halter 50 angebracht, in welchen einzelne, auswechselbare Werkzeuge 16' manuell eingesetzt werden. Der Halter 50 sowie das jeweilige Werkzeug 16' sind unter einem möglichst kleinen Winkel zur Arbeitsfläche 6 geneigt. Bei dieser Variante ist der Schlagbolzen sowie der Schlagkraftsensor 32 im Halter 15 eingebaut. Allerdings wird auch bei dieser Variante einerseits die Einstellung des Werkzeuges 16' zur Heizachse A bzw. zur Chipkante durch die horizontale Verstellung der Einrichtung 15 durchgeführt, und anderseits die statischen Scherkraft horizontal erzeugt (der Einrichtung 15 ist wiederum der Teil 20 zur Erzeugung der statischen Scherkraft zugeordnet).

In Fig. 4 ist ein im wesentlichen dem Chipentferner 1 nach Fig. 1 und 2 entsprechender, wiederum mit einem Werkzeugkopf 17 ausgerüsteter Chipentferner 1b dargestellt, bei dem jedoch die auswechselbaren, der jeweiligen Chipgrösse entsprechenden Heizelemente 45 in einem verstellbaren Magazin, gegebenenfalls einem um eine Achse B drehverstellbaren Revolverkopf 53, untergebracht sind. Die Heizelemente 45 sind an Tragarmen 55 angebracht, die tangential am im wesentlichen kegelförmigen Revolverkopf 53 befestigt sind, und die derart ausgebildet sind, dass das zum Einsatz vorgesehene Heizelement 45 durch Drehverstellen des Revolverkopfes 53 mit dem Tragarm 55 in eine zur Heizachse A koaxiale Stellung gebracht werden kann. Der Revolverkopf 53 ist an einem Halter 56 drehverstellbar angeordnet. Der Halter 56 ist auf einer an der Platte 11 angebrachten, zusätzlichen Vertikalführung 57 höhenverstellbar angeordnet, so dass die Vertikalverstellung des Revolverkopfes 53 bzw. das Heranbringen des Heizelementes 45 zur Chipoberfläche unabhängig von der Vertikalverstellung des Halters 38 mit der Wärmequelle 40 und der Temperatursensor-Einheit 41 erfolgen kann.

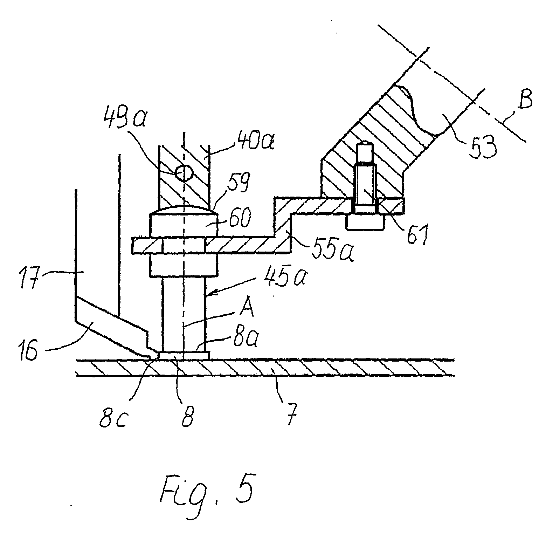

Gemäss Fig. 5 ist die obere Wärmequelle 40a als ein elektrisch direkt geheizter Stempel ausgebildet, der mit einem mit einer sphärischen Fläche 59 versehenen Adapterkopf 60 eines auf die Chipoberfläche 8a aufsetzbaren, im Querschnitt der Chipgrösse entsprechenden Heizelementes 45a in Form eines Zapfens im Kontakt steht. Beim dargestellten Ausführungsbeispiel ist das Heizelement 45a im Querschnitt kleiner als der Adapterkopf 60; für grosse Chips 8 könnte jedoch das Heizelement 45a im Querschnitt auch grösser sein. Das Heizelement 45a ist gegebenenfalls in dem bereits erwähnten, am Revolverkopf 53 mittels einer Schraube 61 befestigten Tragarm 55a eingesetzt. Die mit dem Temperatursensor 49a ausgestattete Wärmequelle 40a wird gemäss Fig. 4 durch Vertikalverstellung des Halters 38 auf das mittels des Revolverkopfes 53 positionierte und mittels des Halters 56 auf die Chipoberfläche 8a aufgesetzte Heizelement 45a angedrückt. Aus Fig. 5 ist auch gut ersichtlich, wie ein im Werkzeugkopf 17 eingesetztes Werkzeug 16 mit einer Chipkante 8c zusammenwirkt.

Im Prinzip wäre es auch möglich, die elektrisch direkt geheizte obere Wärmequelle radial auf das Heizelement 45a bzw. auf den Adapterkopf 60 einwirken zu lassen, wobei die Wärmequelle entsprechend ausgebildet sein müsste (z.B. mit radial verstellbaren Heizbacken o.Ä.).

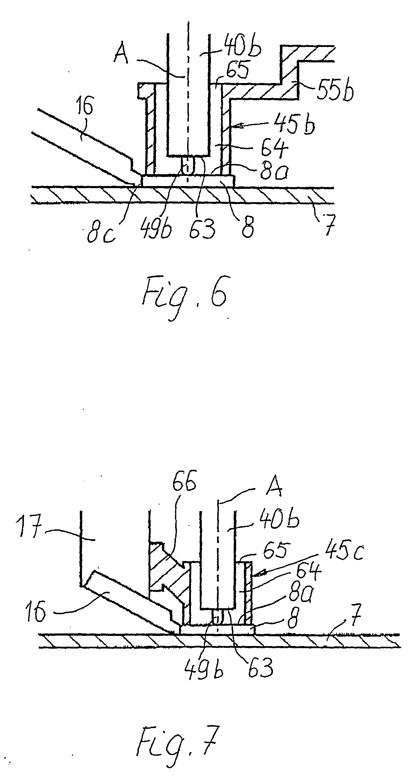

Eine weitere Ausführungsform eines Heizelementes 45b ist in Fig. 6 dargestellt. Als obere Wärmequelle 40b wird ein Heissgasrohr mit einem auf die Chipoberfläche 8a gerichteten Austritt 63 verwendet, durch welches ein auf die Chipoberfläche 8a federnd aufsetzbarer Temperatursensor 49b hindurchragt. Das Heizelement 45b ist als eine auf die Chipoberfläche 8a aufsetzbare, im Querschnitt der Chipgrösse entsprechende Heissgasdüse ausgebildet, in welche das Heissgasrohr 40b axial hineinführbar ist, und die im aufgesetzten Zustand seitlich eine nach oben offene Heissgaskammer 64 begrenzt. Aus der Heissgaskammer 64 kann das zugeführte Heissgas lediglich durch eine obere Öffnung 65, jedoch nicht zu den dem Chip 8 benachbarten Bauteilen (nicht dargestellt) entweichen. Die Heissgasdüse 45b ist mit einem am Revolverkopf 53 (aus Fig. 6 nicht ersichtlich) befestigten Tragarm 55b verbunden.

Wie in Fig. 7 angedeutet, könnte der aus Fig. 1, 2 oder 4 bekannte, drehverstellbare Werkzeugkopf 17 für auswechselbare Werkzeuge 16 gleichzeitig auch als ein Magazin für die auswechselbaren Heizelemente 45 dienen. Als Beispiel ist eine der Ausführung nach Fig. 6 ähnliche Heissgasdüse 45c mit einem Tragarm 66 am Werkzeugkopf 17 angebracht. Allerdings wird bei dieser Lösung einem bestimmten Werkzeug 16 nur ein bestimmtes Heizelement 45 zugeordnet, während bei den Lösungen nach Fig. 4 bis 6 die im Werkzeugkopf 17 vorhandenen Werkzeuge 16 beliebig mit den im Revolverkopf 53 vorhandenen Heizelementen 45 kombinierbar sind.

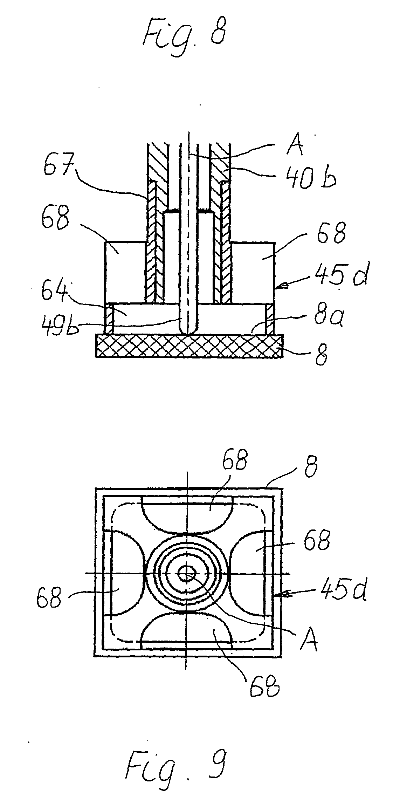

In Fig. 8 und 9 ist ein im Gegensatz zu den Heizelementen 45a bis 45c nach Fig. 5 bis 7 lediglich zusammen mit der Wärmequelle 40b vertikal verstellbares Heizelement 45d dargestellt, das wiederum als eine eine Heissgaskammer 64 seitlich begrenzende Heissgasdüse ausgebildet ist. Im oberen Bereich weist die Heissgasdüse 45d eine Anzahl von Öffnungen 68 auf, durch welche das Heissgas nach oben entweichen kann. Die Heissgasdüse 45d ist mit einem Teil 67 direkt auf die Wärmequelle 40b (ein Heissgasrohr) aufgesetzt. Es ist wiederum der auf die Chipoberfläche 8a federnd aufsetzbarer Temperatursensor 49b vorhanden, der - gleich wie bei den Ausführungen nach Fig. 6 und 7 - ein direktes Messen der Temperatur an der Chipoberfläche 8a während des Erwärmens erlaubt.

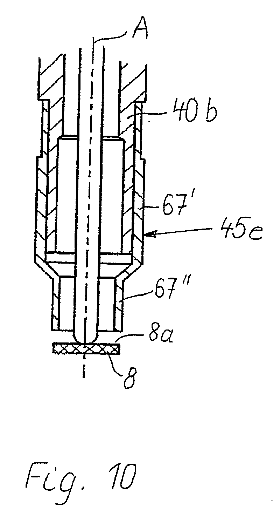

Auch in Fig.10 ist eine direkt auf die Wärmequelle 40b (ein Heissgasrohr) mit einem Teil 67' aufgesetzte Heissgasdüse 45e dargestellt, die sich jedoch im unteren Bereich 67" im Querschnitt verjüngt, und die lediglich zur Erwärmung von kleinen Chips 8 vorgesehen ist, bei den nur kleine Wärmemenge benötigt wird. Die Heissgasdüse 45e wird nicht direkt auf die Chipoberfläche 8a aufgesetzt, sondern lediglich in unmittelbare Nähe derselben gebracht. Das hier seitlich austretende Gas vermag nicht die benachbarten Teile zu gefährden.

Im Prinzip könnte auch ein als eine Wärmequelle 40 und ein Heizgaselement 45 gleichzeitig dienender Wasserstoff-Minibrenner Anwendung finden, den man mit seinem Flammenaustritt in unmittelbare Nähe der Chipoberfläche bringen würde.

Der erfindungsgemässe Chipentferner ist modular aufgebaut und kann je nach Anwendungsberiech konfiguriert werden - mit dem Werkzeugkopf 17 oder nur mit einzelnen Werkzeugen 16' (Fig. 3), mit oder ohne Heizelement-Magazin 53, mit diversen oberen Wärmequellen 40, 40a, 40b, mit diversen Arten von Heizelementen 45 , mit oder ohne Temperatur-und Kraftsensoren etc. Zudem ermöglicht der Chipentferner das Automatisieren von vielen Operationen. Die Chipentfernung kann optimal, d.h. schonend durchgeführt werden, ohne dass Mikrorisse im Chip-Träger 7 entstehen, der wieder mit neuen Chips bestückt werden soll, und ohne dass andere Bauteile in Mitleidenschaft gezogen werden.

## Patentansprüche

1. Chipentferner, mit einer Arbeitsfläche (6) zum Positionieren eines Chip-Trägers (7), mit auswechselbaren Werkzeugen (16, 16') zum Abtrennen eines defekten Chips (8) vom Träger (7) durch eine Scherkrafteinwirkung, wobei die Werkzeuge (16, 16') wahlweise mit einer Einrichtung (15) zum Erzeugen der Scherkraft wirkverbindbar sind, welche Einrichtung (15) gegenüber dem Träger (7) und dem Chip (8) relativ verstellbar ist, und mit einer unteren Wärmequelle (9) für den Träger (7) sowie mit einer oberen Wärmequelle (40, 40a, 40b) für den Chip (8), **dadurch gekennzeichnet, dass** die obere Wärmequelle (40, 40a, 40b) mit einem auf die Chipoberfläche (8a) in einer bezüglich des Chips (8) zentralen Heizachse (A) aufsetzbaren oder in unmittelbare Nähe der Chipoberfläche (8a) bringbaren, der Chipgrösse entsprechenden Heizelement (45, 45a, 45b, 45c, 45d, 45e) wirkverbunden ist, wobei die Einrichtung (15) zum Erzeugen der Scherkraft horizontal verstellbar und dabei das jeweilige Werkzeug (16) in Abhängigkeit von der Chipgrösse gegenüber der Heizachse (A), zu einer Chipkante (8c) hin, einstellbar ist.

2. Chipentferner nach Anspruch 1 , **dadurch gekennzeichnet, dass** der oberen Wärmequelle (40, 40a, 40b) ein die Chipoberfläche (8a) berührender oder in eine unmittelbare Nähe derselben bringbarer Temperatursensor (49, 49a, 49b) zugeordnet ist.

3. Chipentferner nach Anspruch 1 oder 2, **dadurch gekennzeichnet, dass** die Einrichtung (15) zum Erzeugen der Scherkraft einen eine statische Kraft erzeugenden ersten Teil (20) sowie einen eine Schlagkraft erzeugenden zweiten Teil (30) umfasst, wobei die beiden Teile (20, 30) einzeln oder in Kombination anwendbar sind.

4. Chipentferner nach Anspruch 3, **dadurch gekennzeichnet, dass** die beiden Teile (20, 30) der Einrichtung (15) zum Erzeugen der Scherkraft jeweils mit einem Kraftsensor (25, 32) ausgestattet sind.

5. Chipentferner nach Anspruch 3 oder 4, **dadurch gekennzeichnet, dass** der erste Teil (20) eine horizontal gerichtete Schraube (23) aufweist, die einerseits ein Verstellelement zum Einstellen des Werkzeuges (16) gegenüber der Heizachse (A) und anderseits ein Kraftelement zur Erzeugung der statischen Kraft bildet.

6. Chipentferner nach einem der Ansprüche 1 bis 5, **dadurch gekennzeichnet, dass** die auswechselbaren Werkzeuge (16) in einem drehverstellbaren Werkzeugkopf (17) angeordnet und durch Verstellen des Werkzeugkopfes (17) in die Wirkverbindung mit der Einrichtung (15) zum Erzeugen von Scherkraft bringbar sind.

7. Chipentferner nach einem der Ansprüche 1 bis 6, **dadurch gekennzeichnet, dass** ein verstellbares Magazin (53, 17) für auswechselbare, der Chipgrösse entsprechende Heizelemente (45, 45a, 45b, 45c) vorgesehen ist, durch dessen Verstellen die Heizelemente (45, 45a, 45b, 45c) in die Wirkverbindung mit der oberen Wärmequelle (40, 40a, 40b) einerseits und der Chipoberfläche (8a) anderseits bringbar sind.

8. Chipentferner nach einem der Ansprüche 2 bis 7, **dadurch gekennzeichnet, dass** die obere Wärmequelle (40, 40a, 40b) sowie der Temperatursensor (49, 49a, 49b) in einem auf einer Vertikalführung (37) höhenverstellbar geführten Halter (38) angeordnet sind.

9. Chipentferner nach Anspruch 7 und 8, **dadurch gekennzeichnet, dass** das Magazin für auswechselbare, der Chipgrösse entsprechende Heizelemente (45, 45a, 45b) als ein drehverstellbarer Revolverkopf (53) ausgebildet ist, der auf einem zusätzlichen, auf einer Vertikalführung (57) unabhängig von der Vertikalverstellung des Halters (38) für die obere Wärmequelle (40, 40a, 40b) sowie für den Temperatursensor (49, 49a, 49b) vertikal verstellbaren Halter (56) angeordnet ist, wobei das jeweilige Heizelement (45, 45a, 45b) durch das Drehverstellen des Revolverkopfes (53) in eine zur Heizachse (A) koaxiale Stellung bringbar ist.

10. Chipentferner nach 7 oder 8, **dadurch gekennzeichnet, dass** das Magazin für auswechselbare, der Chipgrösse entsprechende Heizelemente (45, 45a, 45b) einen Bestandteil des drehverstellbaren Werkzeugkopfes (17) für die auswechselbaren Werkzeuge (16) bildet.

11. Chipentferner nach einem der Ansprüche 1 bis 10, **dadurch gekennzeichnet, dass** die obere Wärmequelle als ein direkt elektrisch geheizter Stempel (40a) ausgebildet ist, der mit einem vorzugsweise mit einer sphärischen Fläche (59) versehenen Adapterkopf (60) eines auf die Chipoberfläche (8a) aufgesetzten, im Querschnitt der Chipgrösse entsprechenden Heizelementes (45a) in Form eines Zapfens in Kontakt bringbar ist.

12. Chipentferner nach einem der Ansprüche 1 bis 10, **dadurch gekennzeichnet, dass** die obere Wärmequelle als ein Heissgasrohr (40b) mit einem auf die Chipoberfläche (8a) gerichteten Austritt (63) ausgebildet ist, wobei das Heizelement durch eine auf die Chipoberfläche (8a) aufsetzbare, im Querschnitt der Chipgrösse entsprechende Heissgasdüse (45b, 45c) gebildet ist, in welche das Heissgasrohr (40b) axial hineinführbar ist, und die im aufgesetzten Zustand seitlich eine nach oben offene Heissgaskammer (64) begrenzt.

13. Chipentferner nach einem der Ansprüche 1 bis 10, **dadurch gekennzeichnet, dass** die obere Wärmequelle als ein Heissgasrohr (40b) mit einem auf die Chipoberfläche (8a) gerichteten Austritt (63) ausgebildet ist, wobei das Heizelement (45d, 45e) durch eine mit dem Heissgasrohr (40b) fest verbundene, und mit diesem zusammen auf die Chipoberfläche (8a) aufsetzbare oder in unmittelbare Nähe der Chipoberfläche (8a) bringbare Heissgasdüse (45d, 45e) gebildet ist.

14. Chipentferner nach Anspruch 12 oder 13, **dadurch gekennzeichnet, dass** durch das Heissgasrohr (40b) ein auf die Chipoberfläche (8a) federnd aufsetzbarer Temperatursensor (49b) hindurchragt.

15. Verfahren zum Betrieb des Chipentferners nach einem der Ansprüche 3 bis 14, **dadurch gekennzeichnet, dass** entweder nach einer anfänglichen Erwärmung des Chips (8) auf eine vorgegebene Temperatur eine zur Trennung des Chips (8) vom Träger (7) notwendige statische Kraft und/oder Schlagkraft erzeugt wird, oder beim Einstellen und Ausüben einer vorgegebenen statischen Kraft die Temperatur des Chips (8) allenfalls auf einen zur Trennung des Chips (8) vom Träger (7) notwendigen Wert erhöht wird.

16. Verwendung des Chipentferners nach einem der Ansprüche 1 bis 12 zur Durchführung eines Schertests für eine Chip/Chip-Träger-Verbindung.

## Claims

1. Chip remover, with a work surface (6) for positioning a chip carrier (7), with replaceable tools (16, 16') for removing a defective chip (8) from a carrier (7) by means of shear force induction, whereby the tools (16, 16') can be selectively and co-operatively connected with a means (15) for generating the shear force, said means (15) being relatively adjustable in relation to the carrier (7) and the chip (8), and with a lower heat source (9) for the carrier (7) as well as an upper heat source (40, 40a, 40b) for the chip (8), **characterised in that** the upper heat source (40, 40a, 40b) is co-operatively connected with a heater element (45, 45a, 45b, 45c, 45d, 45e) of the size of the chip that can be placed on or in the immediate vicinity of the chip surface (8a) along a heater axis (A) that is central in relation to the chip surface (8a) of the chip (8), whereby the means (15) for generating the shear force is horizontally adjustable and the relevant tool (16) is adjustable in relation to the heater axis (A) and a chip edge (8c) depending on the chip size.

2. Chip remover according to Claim 1, **characterised in that** the upper heat source (40, 40a, 40b) is equipped with a temperature sensor (49, 49a, 49b) that contacts the chip surface (8a) or can be brought into the immediate vicinity of the same.

3. Chip remover according to Claim 1 or 2, **characterised in that** the means (15) for generating the shear force comprises a static force generating first part (20) as well as an impact force generating second part (30), whereby the two parts (20, 30) can be used individually or in combination.

4. Chip remover according to Claim 3, **characterised in that** the two parts (20, 30) of the means (15) for generating the shear force are each equipped with a force sensor (25, 32).

5. Chip remover according to Claim 3 or 4, **characterised in that** the first part (20) comprises a horizontally aligned screw (23) that firstly forms an adjustment element for adjusting the tool (16) in relation to the heater axis (A), and secondly a force element for generating the static force.

6. Chip remover according to one of the Claims 1 to 5, **characterised in that** the replaceable tools (16) are located in a rotation adjustable tool head (17) and can be brought into a co-operating connection with the means (15) for generating shear force by means of adjusting the tool head profile (17).

7. Chip remover according to one of the Claims 1 to 6, **characterised in that** an adjustable magazine (53, 17) for replaceable heater elements (45, 45a, 45b, 45c) matching the size of the chip is envisaged, the adjusting of which brings the heater elements (45, 45a, 45b, 45c) into cooperative connection with the upper heat source (40, 40a, 40b) on the one hand, and with the chip surface (8a) on the other hand.

8. Chip remover according to one of the Claims 2 to 7, **characterised in that** the upper heat source (40, 40a, 40b) as well as the temperature sensor (49, 49a, 49b) is located in holder (38), the vertical guide (37) of which is height adjustable.

9. Chip remover according to Claim 7 and 8, **characterised in that** the magazine is equipped for replaceable heater elements (45, 45a, 45b) that match the size of the chip in the form of a rotation adjustable revolver head (53) which is located on an additional vertically adjustable holder (56), the vertical guide (57) being adjustable independently from the vertical adjustment of the holder (38) for the upper heat source (40, 40a, 40b) as well as for the temperature sensor (49, 49a, 49b), whereby the relevant heater element (45, 45a, 45b) can be brought into a coaxial position in relation to a heater axis (A) by means of rotation adjustment of the revolver head (53).

10. Chip remover according to Claim 7 or 8, **characterised in that** the magazine for replaceable heater elements (45, 45a, 45b) that match the size of the chip forms a component of the rotation adjustable tool head (17) for the replaceable tools (16).

11. Chip remover according to one of the Claims 1 to 10, **characterised in that** the upper heat source takes the form of a directly electrically heated punch (40a) which can be brought into contact with an adapter head (60) of a heater element (45a) taking the form of a spigot and preferably equipped with a spherical surface (59), the cross-section of which matches the size of the chip, and is applied to the chip surface (8a).

12. Chip remover according to one of the Claims 1 to 10, **characterised in that** the upper heat source takes the form of a hot gas pipe (40b) with an outlet (63) directed onto the chip surface (8a), whereby the heater element is formed by a hot gas nozzle (45b, 45c) that can be placed on the chip surface (8a), the cross-section of which matches the size of the chip, into which the hot gas pipe (40b) can be axially inserted, and which delimits in a sideways direction a hot gas chamber (64) that is open at the top in the positioned condition.

13. Chip remover according to one of the Claims 1 to 10, **characterised in that** the upper heat source takes the form of a hot gas pipe (40b) with an outlet (63) directed onto the chip surface (8a), whereby the heater element (45d, 45e) is formed by a hot gas nozzle (45d, 45e) firmly connected with the hot gas pipe (40b) that can be placed onto the chip surface (8a) or brought into the immediate vicinity of the chip surface (8a) together with the same.

14. Chip remover according to Claim 12 or 13, **characterised in that** a temperature sensor (49a) projects through the hot gas pipe (40b) and can be positioned on the chip surface (8a) in a spring suspended way.

15. Method for operating the chip remover according to one of the Claims 3 to 14, **characterised in that** either a static force and/or impact force necessary for separating the chip (8) from the carrier (7) is generated following the initial heating of the chip (8) to a predetermined temperature, or the temperature of the chip (8) is at least increased to a value necessary for separating the chip (8) from the carrier (7) whilst adjusting and generating a predetermined static force.

16. Use of the chip remover according to one of the Claims 1 to 12 for carrying out a shear test for a chip/chip-carrier connection.

## Revendications

1. Extracteur de puce comportant une surface de travail (6) destinée à positionner un support de puce (7), comportant des outils échangeables (16, 16') pour retirer une puce défectueuse (8) du support (7) par l'effet d'une force de cisaillement, les outils (16, 16') pouvant être reliés de façon sélective à un dispositif (15) destiné à générer la force de cisaillement, lequel dispositif (15) peut être réglé par rapport au support (7) et à la puce (8), et comportant une source de chaleur inférieure (9) pour le support (7) ainsi qu'une source de chaleur supérieure (40, 40a, 40b) pour la puce (8), **caractérisé en ce que** la source de chaleur supérieure (40, 40a, 40b) est reliée à un élément de chauffage (45, 45a, 45b, 45c, 45d, 45e) correspondant à la taille de la puce, qui peut être placé sur la surface de la puce (8a) dans un axe de chauffage central (A) relatif à la puce (8) ou être amené à proximité directe de la surface de la puce (8a), le dispositif (15) destiné à générer la force de cisaillement pouvant être réglé horizontalement et l'outil correspondant (16) pouvant ainsi être réglé en fonction de la taille de la puce par rapport à l'axe de chauffage (A), vers une arête de puce (8c).

2. Extracteur de puce selon la revendication 1, **caractérisé en ce qu'**un capteur de température (49, 49a, 49b) reposant sur la surface de la puce (8a) ou pouvant être amené à proximité directe de celle-ci est affecté à la source de chaleur supérieure (40, 40a, 40b).

3. Extracteur de puce selon la revendication 1 ou 2, **caractérisé en ce que** le dispositif (15) destiné à générer la force de cisaillement comprend une première partie (20) générant une force statique ainsi qu'une seconde partie (30) générant une force de frappe, moyennant quoi les deux parties (20, 30) peuvent être utilisées séparément ou ensemble.

4. Extracteur de puce selon la revendication 3, **caractérisé en ce que** les deux parties (20, 30) du dispositif (15) destiné à générer la force de cisaillement sont équipées respectivement d'un capteur de force (25, 32).

5. Extracteur de puce selon la revendication 3 ou 4, **caractérisé en ce que** la première partie (20) comporte une vis (23) orientée horizontalement, laquelle forme d'une part un élément de réglage destiné à régler l'outil (16) par rapport à l'axe de chauffage (A) et, d'autre part, un élément de force destiné à générer la force statique.

6. Extracteur de puce selon l'une quelconque des revendications 1 à 5, **caractérisé en ce que** les outils échangeables (16) sont disposés dans une tête d'outil (17) pivotante et peuvent être amenés en liaison active, grâce au réglage de la tête d'outil (17), avec le dispositif (15) destiné à générer la force de cisaillement.

7. Extracteur de puce selon l'une quelconque des revendications 1 à 6, **caractérisé en ce qu'**un magasin réglable (53, 17) est prévu pour les éléments de chauffage (45, 45a, 45b, 45c) échangeables correspondants à la taille de la puce, par le réglage duquel les éléments de chauffage (45, 45a, 45b, 45c) peuvent être amenés en liaison active avec la source de chaleur supérieure (40, 40a, 40b), d'une part, et la surface de la puce (8a) d'autre part.

8. Extracteur de puce selon l'une quelconque des revendications 2 à 7, **caractérisé en ce que** la source de chaleur supérieure (40, 40a, 40b) ainsi que le capteur de température (49, 49a, 49b) sont disposés dans un logement (38) réglable en hauteur sur un guide vertical (37)

9. Extracteur de puce selon la revendication 7 et la revendication 8, **caractérisé en ce que** le magasin pour les éléments de chauffage (45, 45a, 45b) échangeables correspondant à la taille de la puce est conçu comme tête de tourelle pivotante (53), laquelle est disposée sur un logement (56) supplémentaire réglable verticalement, sur un guide vertical (57) indépendamment du réglage vertical du logement (38) pour la source de chaleur supérieure (40, 40a, 40b) ainsi que pour le capteur de température (49, 49a, 49b), l'élément de chauffage (45, 45a, 45b) correspondant pouvant être amené dans une position coaxiale par rapport à l'axe de chauffage (A) par la rotation de la tête de tourelle (53).

10. Extracteur de puce selon la revendication 7 ou 8, **caractérisé en ce que** le magasin pour les éléments de chauffage (45, 45a, 45b) échangeables correspondant à la taille de la puce forme une composante de la tête d'outil (17) pivotante pour les outils échangeables (16).

11. Extracteur de puce selon l'une quelconque des revendications 1 à 10, **caractérisé en ce que** la source de chaleur supérieure est conçue comme timbre (40a) chauffé directement électriquement, lequel peut être mis en contact avec de préférence une tête d'adaptateur (60) prévue avec une surface (59) sphérique d'un élément de chauffage (45a) correspondant à la taille de la puce en section transversale placé sur la surface de la puce (8a), sous la forme d'un tourillon.

12. Extracteur de puce selon l'une quelconque des revendications 1 à 10, **caractérisé en ce que** la source de chaleur supérieure est conçue comme câble de gaz chaud (40b) comportant une sortie (63) orientée sur la surface de la puce (8a), l'élément de chauffage étant formé par une buse de gaz chaud (45b, 45c) correspondant à la taille de la puce en section transversale pouvant être placée sur la surface de la puce (8a), dans laquelle le câble de gaz chaud (40b) peut être introduit axialement et laquelle limite latéralement une chambre de gaz chaud (64) ouverte vers le haut lorsqu'elle est placée.

13. Extracteur de puce selon l'une quelconque des revendications 1 à 10, **caractérisé en ce que** la source de chaleur supérieure est conçue comme câble de gaz chaud (40b) comportant une sortie (63) orientée sur la surface de la puce (8a), l'élément de chauffage (45d, 45e) étant formé par une buse de gaz chaud (45d, 45e) reliée au câble de gaz chaud (40b) et pouvant être amenée avec lui à proximité directe de la surface de la puce (8a) ou pouvant être placée sur la surface de la puce (8a).

14. Extracteur de puce selon la revendication 12 ou 13, **caractérisé en ce qu'**un capteur de température (49b) pouvant être placé de façon élastique sur la surface de la puce (8a) dépasse par le câble de gaz chaud (40b).

15. Procédé destiné à faire fonctionner l'extracteur de puce selon l'une quelconque des revendications 3 à 14, **caractérisé en ce que**, soit après un premier réchauffement de la puce (8) à une température prédéfinie, une force statique et/ou une force de cisaillement requise pour séparer la puce (8) du support (7) est générée, ou la température de la puce (8) est dans tous les cas augmentée à une valeur requise pour séparer la puce (8) du support (7) lors du réglage et de l'application d'une force statique prédéfinie.

16. Utilisation de l'extracteur de puce selon l'une quelconque des revendications 1 à 12 pour exécuter un test de cisaillement pour une liaison puce/puce-support.
